# FASCICULE DE BREVET EUROPEEN

(11) **EP 0 813 097 B1**
(45) Date de publication et mention de la délivrance du brevet: **01.03.2006**
(21) Numéro de dépôt: 97401290.8
(22) Date de dépôt: 09.06.1997
(51) Int. Cl.: G02F 2/00, H04B 10/17, H01S 5/50

(54) **Dispositif de mise en forme de signaux optiques binaires et son utilisation pour modifier lesdits signaux**
Vorrichtung zur Regeneration digitaler optischer Signale und ihre Verwendung zur Veränderung derartiger Signale
Digital optical signal regeneration device and its use for modifying digital optical signals

(30) Priorité: 14.06.1996 FR 9607421
(43) Date de publication de la demande: 17.12.1997
(73) Titulaire: ALCATEL, 75008 Paris (FR)
(72) Inventeur: Chiaroni, Dominique, 92160 Antony (FR); Sotom, Michel, 75015 Paris (FR); De Bouard, Dominique, 91700 St Geneviève Des Bois (FR)
(74) Mandataire: Fournier, Michel Robert Marie

(56) Documents cités:
- US-A- 5 264 960
- JOERGENSEN C ET AL: "Wavelength conversion by optimized monolithic integrated Mach-Zehnder interferometer" IEEE PHOTONICS TECHNOLOGY LETTERS, APRIL 1996, IEEE, USA, vol. 8, no. 4, ISSN 1041-1135, pages 521-523, XP000587013
- MIKKELSEN B ET AL: "Polarisation insensitive wavelength conversion of 10 Gbit/s signals with SOAs in a Michelson interferometer" ELECTRONICS LETTERS, 3 FEB. 1994, UK, vol. 30, no. 3, ISSN 0013-5194, pages 260-261, XP000431304

## Description

L'invention se situe dans le domaine des systèmes optoélectroniques utilisés pour la transmission ou le traitement optique de données numériques optiques.

Dans ces systèmes, les informations sont souvent sous la forme de données binaires représentées par des impulsions modulant une onde porteuse optique. Une valeur binaire est donc déterminée en fonction du niveau d'amplitude (ou de puissance) de l'onde optique modulée.

Au cours de la transmission, ce signal subit inévitablement des dégradations qui rendent plus difficile au niveau des récepteurs la détection des niveaux hauts et bas du signal reçu. Dans le domaine de l'amplitude, la qualité d'un signal optique est habituellement définie par deux paramètres : le rapport signal à bruit et le taux d'extinction. Le rapport signal à bruit est défini comme le rapport de la puissance optique du signal à la puissance de bruit dans une bande de longueur d'onde contenant la longueur d'onde de la porteuse du signal. Le taux d'extinction est défini comme le rapport des puissances correspondant respectivement aux niveaux hauts et bas du signal.

L'invention a pour but de proposer un dispositif entièrement optique, c'est-à-dire sans conversion optique-électrique et inversement, qui soit capable d'améliorer la qualité d'un signal optique binaire, c'est-à-dire d'augmenter le taux d'extinction tout en conservant un rapport signal à bruit le plus grand possible. En d'autres termes, le dispositif doit être capable à partir d'un signal d'entrée modulé de mauvaise qualité de fournir un signal de sortie dont les niveaux hauts sont stabilisés avec une puissance optique constante, dont les niveaux bas ont une puissance pratiquement nulle, tout en présentant un rapport signal à bruit très élevé.

Une solution envisageable pour augmenter le taux d'extinction consiste à utiliser une structure interférométrique, par exemple de type Mach-Zehnder, tel que décrite dans le document "Wavelength conversion by optimized monolithic integrated Mach-Zehnder Interferometer" de C. Joergensen et al., Photonics Technology Letters, vol.8, p.521, Avril 1996. La structure se compose de deux branches véhiculant deux ondes cohérentes couplées pour former le signal de sortie. L'une des branches comporte un milieu dont l'indice varie en fonction de la puissance optique qu'elle véhicule et un signal d'entrée est introduit dans cette branche. Les variations de puissance du signal d'entrée modulent alors l'indice et les deux ondes peuvent interférer de façon destructive ou constructive en fonction du niveau de puissance du signal d'entrée.

Une telle structure permet bien d'améliorer le taux d'extinction mais présente l'inconvénient que les conditions d'interférences destructive et constructive sont très contraignantes vis-à-vis du signal d'entrée, en particulier de sa longueur d'onde et surtout de son niveau de puissance à l'état haut. Il en résulte un fonctionnement très sensible aux fluctuations de ces paramètres.

L'invention a pour but de remédier aux inconvénients du dispositif précédent. Dans ce but, l'invention a pour objet un dispositif de mise en forme d'un signal binaire d'entrée ayant la forme d'une première onde optique modulée entre des niveaux bas et hauts de puissance, caractérisés en ce qu'il comporte :
- un premier étage pour fournir, en fonction dudit signal d'entrée, un signal optique modulant ayant la forme d'une seconde onde optique de longueur d'onde déterminée et modulée entre des premiers et des seconds niveaux de puissance, les plus hauts parmi lesdits premiers et seconds niveaux étant stabilisés pour être peu dépendants des fluctuations desdits niveaux bas et hauts du signal d'entrée et
- un second étage comportant une structure interférométrique couplée audit premier étage pour recevoir ledit signal modulant et conçue de façon à fournir un signal de sortie résultant d'une interférence respectivement constructive ou destructive de première et seconde ondes auxiliaires lorsque la puissance du signal modulant est égale respectivement auxdits premiers ou seconds niveaux.

Ainsi, le premier étage a pour rôle de supprimer les fluctuations éventuelles des niveaux hauts du signal modulant introduit dans la structure interférométrique. Il en résulte un fonctionnement stable de cette structure. En outre, le dispositif est indépendant de la valeur ou des fluctuations de la longueur d'onde du signal optique d'entrée ainsi que de sa polarisation.

Selon un mode de réalisation particulier le dispositif est caractérisé en ce que ladite structure interférométrique comporte une première et une seconde branche guidante recevant par des premiers moyens de couplage respectivement une première et une seconde partie d'une troisième onde optique, lesdites branches étant munies respectivement d'un premier et d'un second amplificateur optique semi-conducteur, ledit premier amplificateur recevant par des seconds moyens de couplage ledit signal modulant, lesdits premiers et seconds amplificateurs étant alimentés par des courants électriques ajustés pour fournir respectivement lesdites première et seconde ondes auxiliaires.

Ainsi, en plus de l'effet d'amplification apporté par les amplificateurs semi-conducteurs, on exploite aussi leur propriété de posséder un indice fonction à la fois de la puissance optique totale qu'il reçoit et du courant injecté dans sa couche active. Cela permet donc d'ajuster aisément le point de fonctionnement de la structure interférométrique.

Avantageusement, les premier et second moyens de couplage sont disposés de façon à ce que ledit premier amplificateur fournisse ladite première onde auxiliaire et reçoive ledit signal modulant selon des sens de propagation opposés.

Cette dernière disposition facilite l'extraction du signal de sortie.

D'autre part, le bruit qui accompagne le signal de sortie est essentiellement dû à l'émission spontanée amplifiée ("A S E") produite par les amplificateurs semi-conducteurs de la structure interférométrique. Aussi, pour en atténuer les effets sur le signal de sortie et selon un autre aspect de l'invention, les courants sont ajustés pour que ladite interférence soit destructive lorsque lesdits premiers niveaux sont les plus hauts niveaux du signal modulant.

Selon un mode de réalisation préféré, ledit premier étage comporte un troisième amplificateur semi-conducteur apte à recevoir ledit signal d'entrée ainsi qu'une quatrième onde optique. Le troisième amplificateur et/ou le signal d'entrée sont alors dimensionnés pour placer le troisième amplificateur en état de saturation de gain lorsque le signal d'entrée est à l'état haut. Enfin, le signal modulant est constitué par ladite quatrième onde optique amplifiée par ledit troisième amplificateur.

Avantageusement, le troisième amplificateur est un amplificateur optique semi-conducteur à gain stabilisé. Cette dernière disposition présente l'intérêt que le niveau haut du signal modulant reste constant même si le niveau bas du signal d'entrée subit d'importantes variations. Ceci contribue à améliorer la stabilité de fonctionnement de la structure interférométrique.

Le dispositif de mise en forme selon l'invention peut être avantageusement utilisé pour effectuer des modifications des données reçues. Plus précisément, il permet d'effacer une partie des données d'un signal reçu ou d'y insérer de nouvelles données. L'effacement ou l'inscription de données est par exemple utile dans les matrices de commutation qui traitent des données associées à un en-tête contenant des informations de routage.

Aussi l'invention a également pour objet un procédé pour modifier un signal optique binaire d'entrée, caractérisé en ce qu'il consiste à appliquer ledit signal d'entrée au dispositif de mise en forme selon l'invention et à moduler en puissance lesdites ondes auxiliaires.

En variante, l'invention prévoit en outre de modifier le signal optique binaire d'entrée en modulant en puissance ladite quatrième onde optique ou en modulant le courant électrique appliqué audit troisième amplificateur. En particulier, la modulation de la quatrième onde optique par un signal d'échantillonnage approprié permet à la fois une remise en forme et une resynchronisation d'un signal binaire d'entrée.

D'autres aspects et avantages de l'invention apparaîtront dans la suite de la description en référence aux figures.
- La figure 1 représente schématiquement un mode de réalisation préféré du dispositif selon l'invention.
- Les figures 2 à 4 sont des courbes permettant d'expliquer le principe de fonctionnement du dispositif de la figure 1.
- Les figures 5 à 8 sont des chronogrammes montrant des transformations de signaux optiques binaires effectuées par le dispositif selon l'invention.
- Les figures 9 et 10 sont des variantes de réalisation de la structure interférométrique faisant partie du dispositif selon l'invention.
- La figure 11 est une variante de réalisation du premier étage du dispositif selon l'invention.

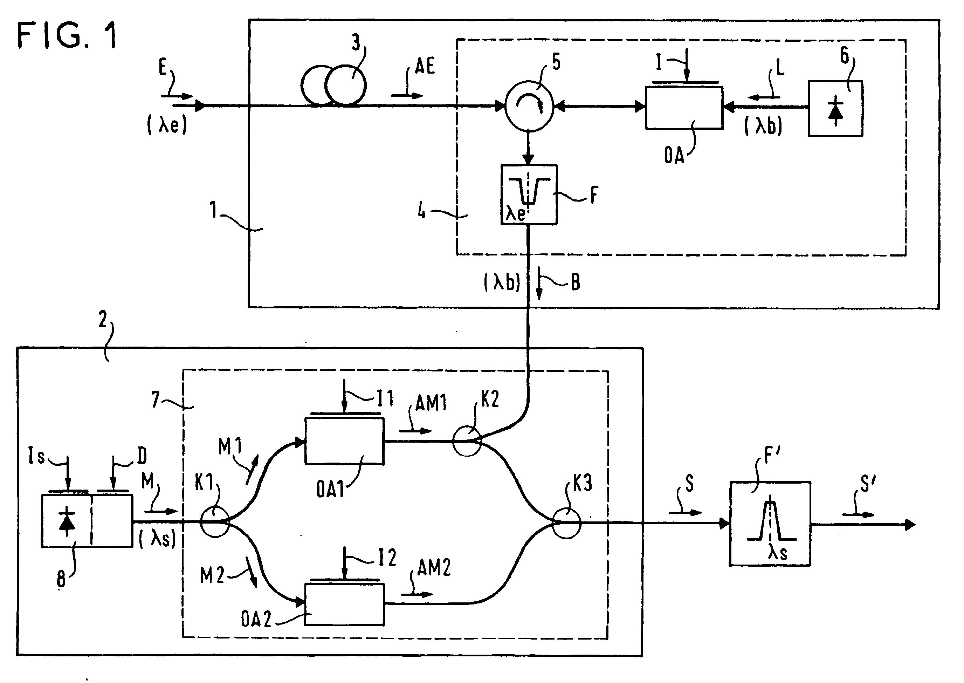

Le dispositif représenté à la figure 1 comprend un premier étage 1 recevant un signal optique binaire d'entrée E destiné à être mis en forme par le dispositif et fournissant à un second étage 2 un signal optique modulant B.

Le premier étage 1 comporte un amplificateur optique à fibres 3 recevant le signal d'entrée E et fournissant un signal d'entrée amplifié AE à un dispositif écrêteur 4. Le dispositif écrêteur 4 comporte un amplificateur optique semi-conducteur OA dont une première face est couplée à un oscillateur laser 6 fournissant une onde porteuse intermédiaire L. L'autre face de l'amplificateur OA est reliée à un circulateur 5 comportant un premier et un second ports prévus respectivement pour recevoir de l'amplificateur à fibres 3 le signal d'entrée amplifié AE et l'injecter dans l'amplificateur OA. Un troisième port du circulateur 5 fournit le signal modulant B par l'intermédiaire d'un filtre réjecteur F calé sur la longueur d'onde λe du signal d'entrée E. La longueur d'onde λb de l'onde intermédiaire L est choisie différente de celle du signal d'entrée E et sera avantageusement modifiable en utilisant comme source 6 un oscillateur laser accordable en longueur d'onde.

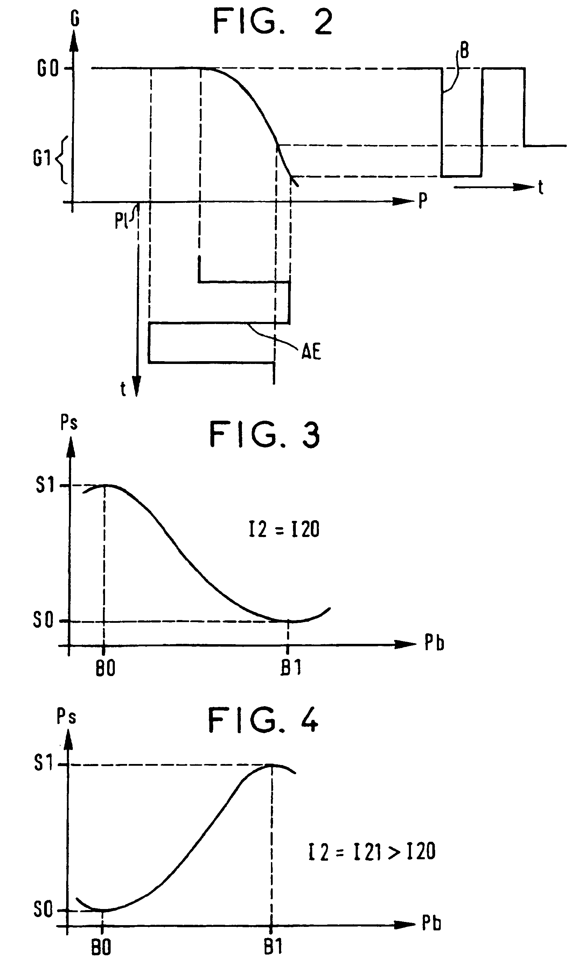

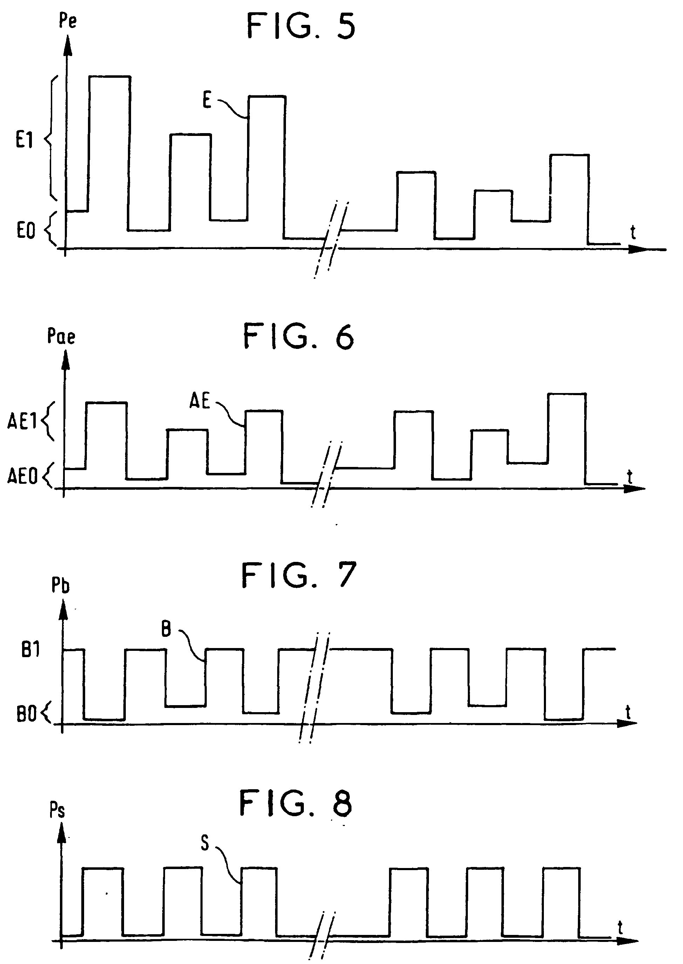

Le fonctionnement du premier étage peut être expliqué à l'aide des figures 2, 5, 6 et 7. La figure 5 représente, à titre d'exemple et de façon schématique, les variations en fonction du temps de la puissance optique Pe du signal d'entrée E. Il est supposé qu'un premier train de données à forte puissance optique moyenne est suivi d'un second train de données à puissance optique moyenne plus faible. Par ailleurs, les niveaux hauts E1 et bas E0 du signal E présentent des fluctuations importantes. L'amplificateur à fibres 3 est prévu pour fonctionner en mode de saturation de gain. Il en résulte une égalisation de la puissance optique moyenne du signal amplifié AE. La figure 6 représente les variations en fonction du temps de la puissance optique Pae du signal amplifié AE.

La figure 2 montre schématiquement les variations du gain G de l'amplificateur OA en fonction de la puissance optique totale P qu'il reçoit. Dans le cas de l'écrêteur 4, la puissance P est la somme de la puissance P1 de l'onde intermédiaire L et de la puissance Pae du signal amplifié AE. La courbe représentée correspond au cas d'un amplificateur à gain stabilisé réalisé par exemple conformément aux enseignements de la demande de brevet européen EP-A-639 876. Un tel amplificateur a la propriété de conserver un gain constant pour une large plage de variations de la puissance optique qu'il reçoit. Par contre, le gain diminue fortement lorsque la puissance dépasse une valeur de seuil caractéristique de l'amplificateur choisi. Grâce à un dimensionnement approprié de l'amplificateur à fibres 3 et/ou de l'amplificateur semi-conducteur OA, la modulation de puissance du signal d'entrée amplifié AE est capable de moduler le gain G entre une valeur haute constante G0 et des valeurs faibles G1. Cette modulation de gain s'applique à l'onde auxiliaire L dont la puissance P1 est constante. Il en résulte que l'amplificateur OA émet en direction du circulateur 5 une onde modulée en puissance dont les niveaux hauts sont pratiquement indépendants des fluctuations des niveaux bas du signal d'entrée E. Ainsi, le signal modulant B obtenu après un éventuel filtrage F présente également cette propriété comme représenté à la figure 7.

Le second étage 2 du dispositif de la figure 1 comporte une structure interférométrique 7 constituée de deux branches guidantes munies respectivement d'amplificateurs optiques semi-conducteurs OA1 et OA2. Un premier coupleur K1 permet de coupler une extrémité de chacune de ces branches à une source laser 8 fournissant une onde porteuse de sortie M de longueur d'onde λs. Un second coupleur K2 est disposé de façon à permettre l'introduction du signal modulant B dans le premier amplificateur OA1. Un troisième coupleur K3 relié au coupleur K2 et au second amplificateur OA2 est disposé de façon à fournir un signal de sortie S résultant du couplage d'ondes auxiliaires AM1 et AM2 fournies respectivement par les amplificateurs OA1 et OA2. Les ondes AM1 et AM2 correspondent aux ondes M1 et M2 issues du coupleur K1 et amplifiées respectivement par les amplificateurs OA1 et OA2.

Des courants I1 et I2 sont injectés respectivement dans les amplificateurs OA1 et OA2. Selon une première possibilité, ces courants sont ajustés de façon à ce que le signal de sortie S résulte d'une interférence constructive des ondes AM1 et AM2 lorsque la puissance du signal modulant B est basse et résulte d'une interférence destructive dans le cas contraire. Ce cas est illustré à la figure 3 qui représente la puissance de sortie Ps du signal S en fonction de la puissance Pb du signal modulant B lorsque le courant I2 a la valeur 120.

Selon une autre possibilité, le courant 12 peut être ajustés à une valeur I21 supérieure à I20 pour obtenir une réponse de la structure interférométrique 7 conformément à la figure 4. Dans ce cas, l'interférence est destructive lorsque la puissance du signal B est faible et constructive lorsqu'elle est élevée.

Ainsi, dans le cas d'une réponse conforme à la figure 3, les variations de la puissance Ps du signal de sortie en fonction du temps seront représentées conformément à la figure 8. L'ensemble peut être complété par un filtre de sortie F' calé sur la longueur d'onde λs de façon à éliminer les émissions spontanées amplifiées produites par les amplificateurs OA1 et OA2.

L'ensemble qui vient d'être présenté permet donc une excellente remise en forme du signal d'entrée en tolérant de fortes fluctuations de ses niveaux hauts et bas. Le premier étage a notamment pour rôle de stabiliser le fonctionnement de la structure interférométrique 7 du second étage 2 tandis que ce dernier a pour rôle de régénérer le taux d'extinction dégradé par le premier étage.

Dans le cas où la source 6 est accordable en longueur d'onde, on choisira avantageusement une longueur d'onde λb qui assure un gain maximal à l'amplificateur OA1 pour le courant d'injection I1 choisi.

Concernant le choix des courants I1 et I2 dans le cas par exemple de la réponse selon la figure 3, on peut utiliser la méthode suivante. On applique un courant Il élevé, par exemple de 200 mA, avec un signal B de puissance nulle et on cherche la valeur I20 du courant I2 telle que la puissance Ps du signal de sortie soit maximale S1. Ensuite, en conservant les mêmes courants, on recherche la puissance B1 du signal B à injecter pour que la puissance de sortie Ps soit minimale S0. On cherche enfin la valeur du courant I à injecter dans l'amplificateur OA de l'écrêteur 4 pour que le niveau haut de puissance du signal B soit égal à la valeur B1 précédemment déterminée.

Pour effectuer des modifications du signal d'entrée en utilisant le dispositif qui vient d'être décrit, il convient de prévoir des moyens permettant de moduler la puissance des ondes auxiliaires AM1 et AM2. Pour cela, on peut par exemple utiliser comme source 8 un laser à modulateur intégré. Un courant Is est alors injecté dans la partie laser tandis qu'une tension de modulation D est appliquée en inverse sur la partie modulateur. Avec un tel dispositif, il est possible d'effacer les données d'entrée en annulant la puissance optique de l'onde M fournie par la modulateur. Dans le cas où l'interférence est destructive lorsque le signal B est à l'état haut, on pourra insérer des données lorsque ce signal B est à l'état bas en modulant la puissance de l'onde M par modulation de la tension D. Dans le cas où l'interférence est constructive lorsque le signal B est à l'état haut, on pourra insérer des données lorsque ce signal est à l'état haut en modulant la puissance du signal M comme précédemment.

Des modifications du signal d'entrée peuvent aussi être effectuées en modulant la puissance P1, par exemple au moyen d'un modulateur placé entre la source 6 et l'amplificateur OA. Cette possibilité peut être avantageusement utilisée pour resynchroniser un signal d'entrée E synchrone, c'est-à-dire supprimer la gigue pouvant l'affecter. Par exemple, dans le cas d'un signal d'entrée de type NRZ, il suffit pour cela de moduler la puissance P1 par un signal d'horloge d'échantillonnage (non représenté sur la figure) constitué d'impulsions de largeur inférieure au temps bit du signal d'entrée, de fréquence égale à la fréquence bit et calées environ au milieu des intervalles de temps bit du signal. Si la durée des impulsions est égale à la moitié du temps bit du signal d'entrée, on peut obtenir en sortie un signal de type RZ.

Si par contre on veut fournir un signal de sortie S de type NRZ, on peut simplement ajuster les courants I1 et I2 de façon à ce que la bande passante de l'amplificateur OA1, donc du second étage 2, présente une fréquence de coupure comprise entre la fréquence bit et la moitié de cette fréquence.

On peut également procéder à des effacements partiels du signal en modulant le courant I qui alimente l'amplificateur OA.

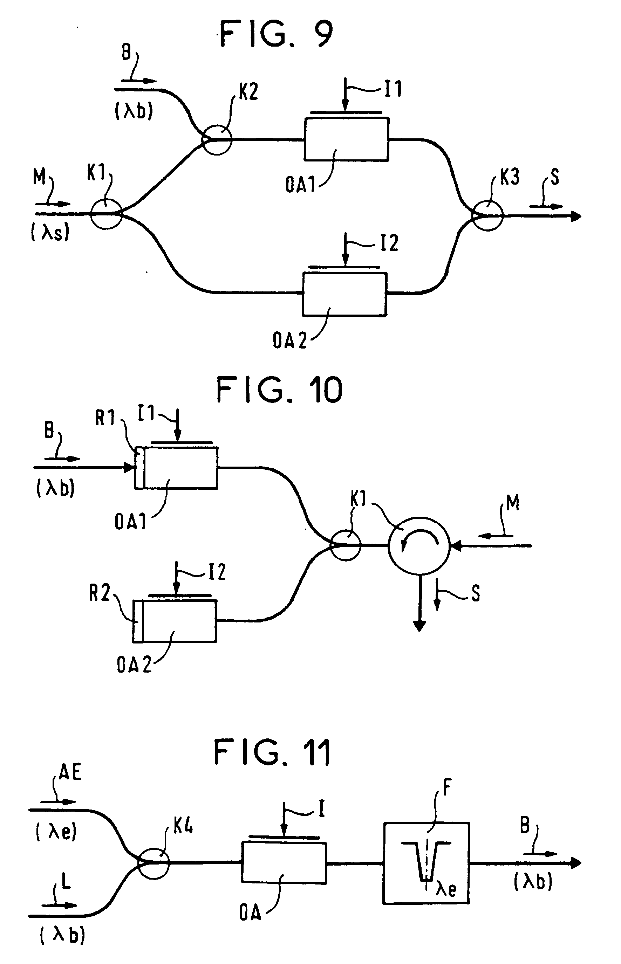

La figure 9 représente une variante de réalisation de la structure interférométrique 7. la structure est aussi de type Mach-Zehnder mais le signal modulant B et l'onde M sont injectés dans le premier amplificateur OA1 selon le même sens de propagation. Le fonctionnement est analogue à celui de la structure représentée à la figure 1 à la différence près qu'un filtre de sortie F' capable d'éliminer efficacement la longueur d'onde λb soit placé en sortie du dispositif.

La figure 10 représente une autre structure de type Michelson équivalente à la précédente. Selon cette variante, les deux amplificateurs OA1 et OA2 sont couplés par une seule de leurs extrémités, les faces opposées étant munies d'un revêtement réfléchissant R1, R2. Le signal modulant est injecté dans le premier amplificateur OA1 par l'intermédiaire de la face R1 et l'onde M est injectée dans les deux amplificateurs OA1 et OA2 par les faces opposées aux faces R1 et R2 par l'intermédiaire d'un ensemble K1 formé d'un circulateur associé à un coupleur. Un premier port du circulateur reçoit l'onde M, le second port est couplé aux deux amplificateurs OA1, OA2 et un troisième port fournit le signal de sortie S.

La figure 11 représente une variante de réalisation de l'écrêteur 4. Le principe de fonctionnement est analogue à celui du dispositif représenté à la figure 1 à la différence près que l'onde L et le signal d'entrée amplifié AE sont injectés dans l'amplificateur OA avec le même sens de propagation. Il est alors nécessaire de prévoir un filtre réjecteur F capable d'éliminer efficacement la longueur d'onde λe du signal d'entrée.

On peut noter que dans la réalisation de l'écrêteur 4 de la figure 1, il est possible de supprimer le filtre F en prévoyant des traitements antireflet sur les faces de l'amplificateur OA. Dans ce cas, il sera facile d'intégrer dans un même composant les trois amplificateurs OA, OA1, OA2, à condition toutefois de remplacer le circulateur 5 par un simple coupleur.

## Revendications

1. Dispositif de mise en forme d'un signal optique d'entrée (E) ayant la forme d'une première onde optique modulée entre des niveaux bas et hauts (E0, E1) de puissance, comportant:
- un premier étage (1) pour fournir, en fonction dudit signal d'entrée (E), un signal optique modulant (B) ayant la forme d'une seconde onde optique de longueur d'onde déterminée (λb) et modulée entre des premiers et des seconds niveaux de puissance (B0, B1), ledit premier étage comportant des moyens de stabilisation en puissance, adaptés à stabiliser en puissance les plus hauts (B1) parmi lesdits premiers et seconds niveaux (B0, B1) pour qu'ils soient peu dépendants des fluctuations desdits niveaux bas et hauts (E0, E1) du signal d'entrée (E) et
- un second étage (2) comportant une structure interférométrique (7) couplée audit premier étage (1) pour recevoir ledit signal modulant (B), la structure interférométrique comprenant des moyens pour générer deux ondes auxiliaires (AM1, AM2) et des moyens de modification de la différence de phase entre les deux ondes auxiliaires, de façon à fournir un signal de sortie (S) résultant d'une interférence respectivement constructive ou destructive de première et seconde ondes auxiliaires (AM1, AM2) lorsque la puissance du signal modulant (B) est égale respectivement auxdits premiers ou seconds niveaux (B0, B1).

2. Dispositif selon la revendication 1, **caractérisé en ce que** ladite structure interférométrique (7) comporte une première et une seconde branche guidante recevant par des premiers moyens de couplage (K1) respectivement une première et une seconde partie (M1, M2) d'une troisième onde optique (M), lesdites branches étant munies respectivement d'un premier et d'un second amplificateur optique semi-conducteur (OA1, OA2), ledit premier amplificateur (OA1) recevant par des seconds moyens de couplage (K2) ledit signal modulant (B), lesdits premiers et seconds amplificateurs (OA1, OA2) étant alimentés par des courants électriques (I1, I2) ajustés pour fournir respectivement lesdites première et seconde ondes auxiliaires (AM1, AM2).

3. Dispositif selon la revendication 2, **caractérisé en ce que** lesdits premier et second moyens de couplage (K1, K2) sont disposés de façon à ce que ledit premier amplificateur (OA1) fournisse ladite première onde auxiliaire (AM1) et reçoive ledit signal modulant (B) selon des sens de propagation opposés.

4. Dispositif selon l'une des revendications 2 à 3, **caractérisé en ce que** lesdits courants (I1, I2) sont ajustés pour que ladite interférence soit destructive lorsque lesdits premiers niveaux sont les plus hauts niveaux (B1) du signal modulant (B).

5. Dispositif selon l'une des revendications 1 à 4, **caractérisé en ce que** ledit premier étage (1) comporte un troisième amplificateur semi-conducteur (OA) apte à recevoir ledit signal d'entrée (E) ainsi qu'une quatrième onde optique (L), **en ce que** ledit troisième amplificateur (OA) et/ou ledit signal d'entrée (E) sont dimensionnés pour placer ledit troisième amplificateur (OA) en état de saturation de gain lorsque le signal d'entrée (E) est à l'état haut (El) et **en ce que** ledit signal modulant (B) est constitué par ladite quatrième onde optique (L) amplifiée par ledit troisième amplificateur (OA).

6. Dispositif selon la revendication 5, **caractérisé en ce que** ledit troisième amplificateur (OA) est un amplificateur optique semi-conducteur à gain stabilisé.

7. Dispositif selon l'une des revendications 5 ou 6, **caractérisé en ce que** ladite quatrième onde (L) a une longueur d'onde (λb) qui correspond au maximun de gain du premier amplificateur (OA1).

8. Dispositif selon l'une des revendications 5 à 7, **caractérisé en ce que** ledit premier étage (1) comporte un amplificateur optique à fibres (3) apte à fonctionner en mode de saturation de gain et disposé de façon à amplifier ledit signal d'entrée (E) avant de l'appliquer audit troisième amplificateur (OA).

9. Procédé pour modifier un signal optique binaire d'entrée (E), **caractérisé en ce qu'**il consiste à appliquer ledit signal d'entrée (E) au dispositif de mise en forme selon l'une des revendications 1 à 8 et à moduler en puissance lesdites ondes auxiliaires (AM1, AM2).

10. Procédé pour modifier un signal optique binaire d'entrée (E), **caractérisé en ce qu'**il consiste à appliquer ledit signal d'entrée (E) au dispositif de mise en forme selon l'une des revendications 2 à 4 et à moduler en puissance ladite troisième onde optique (M).

11. Procédé pour modifier un signal optique binaire d'entrée (E), **caractérisé en ce qu'**il consiste à appliquer ledit signal d'entrée (E) au dispositif de mise en forme selon l'une des revendications 5 à 8 et à moduler en puissance ladite quatrième onde optique (L).

12. Procédé selon la revendication 11, **caractérisé en ce que** ladite quatrième onde optique (L) est modulée par un signal d'horloge d'échantillonnage constitué d'impulsions de largeur inférieure au temps bit du signal d'entrée (E), de fréquence égale à celle du signal d'entrée (E) et calées environ au milieu des intervalles de temps bit du signal d'entrée (E).

13. Procédé selon la revendication 12, **caractérisé en ce que** ledit second étage (2) est prévu pour présenter une fréquence de coupure comprise entre la fréquence bit du signal d'entrée (E) et la moitié de cette fréquence.

14. Procédé pour modifier un signal optique binaire d'entrée (E), **caractérisé en ce qu'**il consiste à appliquer ledit signal d'entrée (E) au dispositif de mise en forme selon l'une des revendications 5 à 8 et à moduler le courant électrique (I) appliqué audit troisième amplificateur (OA).

## Patentansprüche

1. Vorrichtung zur Regeneration eines optischen Eingangssignals (E), das die Form einer ersten optischen Welle hat, die zwischen niedrigen und hohen Leistungspegeln (E0, E1) moduliert wird, und folgendes beinhaltet:
- eine erste Stufe (1), um in Abhängigkeit von diesem Eingangssignal (E) ein modulierendes optisches Signal (B) zu liefern, das die Form einer zweiten optischen Welle mit einer bestimmten Wellenlänge (λb) hat und zwischen ersten und zweiten Leistungspegeln (B0, B1) moduliert wird, wobei diese erste Stufe Mittel zur leistungsmäßigen Stabilisierung beinhaltet, die dafür geeignet sind, die höchsten (B1) unter den genannten ersten und zweiten Pegeln (B0, B1) leistungsmäßig zu stabilisieren, damit sie kaum abhängig sind von den Schwankungen der genannten niedrigen und hohen Pegel (E0, E1) des Eingangssignals (E) und
- eine zweite Stufe (2), die eine an diese erste Stufe (1) gekoppelte interferometrische Struktur (7) beinhaltet, um dieses modulierende Signal (B) zu empfangen, wobei die interferometrische Struktur Mittel enthält, um zwei Hilfswellen (AM1, AM2) zu erzeugen und Mittel zum Modifizieren der Phasendifferenz zwischen den beiden Hilfswellen, so dass ein Ausgangssignal (S) geliefert wird, das sich aus einer konstruktiven beziehungsweise destruktiven Interferenz von erster und zweiter Hilfswelle (AM1, AM2) ergibt, wenn die Leistung des modulierenden Signals (B) gleich diesen ersten beziehungsweise zweiten Pegeln (B0, B1) ist.

2. Vorrichtung gemäß Anspruch 1, **dadurch gekennzeichnet, dass** diese interferometrische Struktur (7) einen ersten und einen zweiten leitenden Zweig enthält, die durch erste Kopplungsmittel (K1) einen ersten beziehungsweise einen zweiten Teil (M1, M2) einer dritten optischen Welle (M) empfangen, wobei diese Zweige mit einem ersten beziehungsweise einem zweiten optischen Halbleiter-Verstärker (OA1, OA2) versehen sind, dieser erste Verstärker (OA1) durch zweite Kopplungsmittel (K2) dieses modulierende Signal (B) empfängt, diese ersten und zweiten Verstärker (OA1, OA2) durch elektrische Ströme (I1, 12) gespeist werden, die so eingeregelt sind, dass sie die erste beziehungsweise zweite Hilfswelle (AM1, AM2) liefern.

3. Vorrichtung gemäß Anspruch 2, **dadurch gekennzeichnet, dass** das erste und das zweite Kopplungsmittel (K1, K2) so angeordnet sind, dass dieser erste Verstärker (OA1) diese erste Hilfswelle (AM1) liefert und dieses modulierende Signal (B) entsprechend entgegen gesetzten Ausbreitungsrichtungen empfängt.

4. Vorrichtung gemäß einem der Ansprüche 2 bis 3, **dadurch gekennzeichnet, dass** diese Ströme (11, 12) so eingeregelt sind, dass diese Interferenz destruktiv ist, wenn diese ersten Pegel die höchsten Pegel (B1) des modulierenden Signals (B) sind.

5. Vorrichtung gemäß einem der Ansprüche, 1 bis 4, **dadurch gekennzeichnet, dass** diese erste Stufe (1) einen dritten Halbleiter-Verstärker (OA) beinhaltet, der im Stande ist, dieses Eingangssignal (E) zu empfangen, sowie eine vierte optische Welle (L), dass dieser dritte Verstärker (OA) und/oder dieses Eingangssignal (E) so ausgelegt sind, dass dieser dritte Verstärker (OA) im Zustand der Verstärkungssättigung ist, wenn das Eingangssignal (E) im hohen Zustand (E1) ist, und **dadurch gekennzeichnet, dass** das modulierende Signal (B) aus der bezeichneten vierten optischen Welle (L) besteht, die durch den bezeichneten dritten Verstärker (OA) verstärkt wird.

6. Vorrichtung gemäß Anspruch 5, **dadurch gekennzeichnet, dass** dieser dritte Verstärker (OA) ein optischer Halbleiter-Verstärker mit stabilisierter Verstärkung ist.

7. Vorrichtung gemäß Anspruch 5 oder 6, **dadurch gekennzeichnet, dass** diese vierte Welle (L) eine Wellenlänge (λb) hat, die dem Verstärkungsmaximum des ersten Verstärkers (OA1) entspricht.

8. Vorrichtung gemäß einem der Ansprüche 5 bis 7, **dadurch gekennzeichnet, dass** diese erste Stufe (1) einen optischen Faserverstärker (3) beinhaltet, der im Stande ist, im Verstärkungssättigungsmodus zu arbeiten und so angeordnet ist, dass dieses Eingangssignal (E) verstärkt wird bevor es auf den bezeichneten dritten Verstärker (OA) angewandt wird.

9. Verfahren zum Modifizieren eines digitalen optischen Eingangssignals (E), **dadurch gekennzeichnet, dass** es darin besteht, das bezeichnete Eingangssignal (E) an die Regenerationsvorrichtung gemäß einem der Ansprüche 1 bis 8 anzulegen und die bezeichneten Hilfswellen (AM1, AM2) hinsichtlich ihrer Leistung zu modulieren.

10. Verfahren zum Modifizieren eines digitalen optischen Eingangssignals (E), **dadurch gekennzeichnet, dass** es darin besteht, das bezeichnete Eingangssignal (E) an die Vorrichtung zur Regeneration gemäß einem der Ansprüche 2 bis 4 anzulegen und die bezeichnete dritte optische Welle (M) hinsichtlich ihrer Leistung zu modulieren.

11. Verfahren zum Modifizieren eines digitalen optischen Eingangssignals (E), **dadurch gekennzeichnet, dass** es darin besteht, das bezeichnete Eingangssignal (E) an die Vorrichtung zur Regeneration gemäß einem der Ansprüche 5 bis 8 anzulegen und die bezeichnete vierte optische Welle (L) hinsichtlich ihrer Leistung zu modulieren.

12. Verfahren gemäß Anspruch 11, **dadurch gekennzeichnet, dass** diese vierte optische Welle (L) durch ein Abtastungsuhrsignal moduliert wird, das aus Impulsen mit einer Breite unter der Bitzeit des Eingangssignals (E), mit einer Frequenz gleich derjenigen des Eingangssignals (E) und ungefähr auf die Mitte der Bitzeitintervalle des Eingangssignals (E) eingestellt besteht.

13. Verfahren gemäß Anspruch 12, **dadurch gekennzeichnet, dass** die bezeichnete zweite Stufe (2) dafür vorgesehen ist, eine Grenzfrequenz zwischen der Bitfrequenz des Eingangssignals (E) und der Hälfte dieser Frequenz aufzuweisen.

14. Verfahren zum Modifizieren eines digitalen optischen Eingangssignals (E), **dadurch gekennzeichnet, dass** es darin bestcht, das bezeichnete Eingangssignal (E) an die Vorrichtung zur Regeneration gemäß einem der Ansprüche 5 bis 8 anzulegen und den elektrischen Strom (1), der an diesen dritten Verstärker (OA) angelegt wird, zu modulieren.

## Claims

1. Apparatus for shaping an input optical signal (E) in the form of a first light wave modulated between low and high power levels (E0, E1), the apparatus comprising:
· a first stage (1) for delivering a modulating optical signal (E) as a function of said input signal (B), the modulating signal being in the form of a second light wave of determined wavelength (λb) and being modulated between first and second power levels (B0, B1), said first stage comprising power stabilizing means adapted to stabilize the power of the high level (B1) of said first and second levels (B0, B1) so that it depends little on fluctuations of said low and high levels (E0, E1) of the input signal (E); and
· a second stage (2) comprising an interferometer structure (7) coupled to said first stage (1) to receive said modulating signal (B), the interferometer structure comprising means for generating two auxiliary waves (AM1, AM2), and means for modifying the phase difference between the two auxiliary waves, so as to deliver an output signal (S) that is the result of interference between first and second auxiliary waves (AM1, AM2), which interference is respectively constructive and destructive when the power of the modulating signal (B) is respectively equal to said first and second levels (B0, B1).

2. Apparatus according to claim 1, **characterized in that** said interferometer structure (7) comprises first and second light guide branches respectively receiving first and second portions (M1, M2) of a third light wave (M) via coupling means (K1), said branches being respectively provided with first and second semiconductor optical amplifiers (OA1, OA2), said first amplifier (OA1) receiving said modulating signal (B) via second coupling means (K2), said first and second amplifiers (OA1, OA2) being fed with electric currents (I1, I2) adjusted to deliver said first and second auxiliary waves (AM1, AM2) respectively.

3. Apparatus according to claim 2, **characterized in that** said first and second coupling means (K1, K2) are disposed so that said first amplifier (OA1) supplies said first auxiliary wave (AM1) and receives said modulating signal (B) in opposite propagation directions.

4. Apparatus according to claim 2 or 3, **characterized in that** said currents (I1, 12) are adjusted so that the interference is destructive when said first levels are the high levels (B1) of the modulating signal (B).

5. Apparatus according to any one of claims 1 to 4, **characterized in that** said first stage (1) includes a third semiconductor amplifier (OA) suitable for receiving said input signal (E) and a fourth light wave (L), **in that** said third amplifier (OA) and/or said input signal (E) are dimensioned to place said third amplifier (OA) in a gain-saturation state when the input signal (E) is in the high state (E1), and **in that** said modulating signal (B) is constituted by said fourth light wave (L) amplified by said third amplifier (OA).

6. Apparatus according to claim 5, **characterized in that** said third amplifier (OA) is a gain-stabilized semiconductor optical amplifier.

7. Apparatus according to claim 5 or 6, **characterized in that** the fourth wave (L) has a wavelength (λb) which corresponds to the maximum gain for the first amplifier (OA1).

8. Apparatus according to any one of claims 5 to 7, **characterized in that** said first stage (1) includes an optical fiber amplifier (3) suitable for operating in gain saturation mode and disposed so as to amplify said input signal (E) prior to applying it to said third amplifier (OA).

9. A method of modifying an input binary optical signal (E), **characterized in that** it consists in applying said input signal (E) to the shaping apparatus according to any one of claims 1 to 8, and in power modulating said auxiliary waves (AM1, AM2).

10. A method of modifying an input binary optical signal (E), **characterized in that** it consists in applying said input signal (E) to the shaping apparatus according to any one of claims 2 to 4, and in power modulating said third light wave (M).

11. A method of modifying an input binary optical signal (E), **characterized in that** it consists in applying said input signal (E) to the shaping apparatus according to any one of claims 5 to 8, and in power modulating said fourth light wave (L).

12. A method according to claim 11, **characterized in that** said fourth light wave (L) is modulated by a sampling clock signal constituted by pulses of width narrower than the bit time of the input signal (E), of frequency equal to that of the input signal (E), and set approximately to the middles of the bit time intervals of the input signal (E).

13. A method according to claim 12, **characterized in that** said second stage (2) is designed to have a cutoff frequency lying between the bit frequency of the input signal (E) and half said frequency.

14. A method of modifying an input binary optical signal (E), **characterized in that** it consists in applying said input signal (E) to the shaping apparatus according to any one of claims 5 to 8, and in modulating the electric current (I) applied to said third amplifier (OA).
